# EUROPEAN PATENT SPECIFICATION

(11) **EP 2 188 891 B1**
(45) Date of publication and mention of the grant of the patent: **31.07.2019**
(21) Application number: 08830020.7
(22) Date of filing: 12.09.2008
(51) Int. Cl.: H03G 3/30, H03D 7/16, H03D 7/14

(54) **LOCAL OSCILLATOR BUFFER AND MIXER HAVING ADJUSTABLE SIZE**
LOKALOSZILLATOR PUFFER UND MISCHER MIT AUSWÄHLBARER GRÖSSE
MÉMOIRE TAMPON D'OSCILLATEUR LOCAL ET MÉLANGEUR AYANT UNE TAILLE RÉGLABLE

(30) Priority: 14.09.2007 US 855997; 30.10.2007 US 983879 P; 12.12.2007 US 955201; 11.09.2008 US 209164
(43) Date of publication of application: 26.05.2010
(60) Divisional application: 19182306.1
(73) Proprietor: QUALCOMM Incorporated, San Diego, California 92121-1714 (US)
(72) Inventor: ANIRUDDHAN, Sankaran, San Diego CA 92121-1714 (US); NARATHONG, Chiewcharn, San Diego CA92121-1714 (US); SRIDHARA, Sriramgopal, San Diego CA 92121-1714 (US); SRIDHARA, Ravi, San Diego CA 92121-1714 (US); SAHOTA, Gurkanwal, Singh, San Diego CA 92103 (US); BOSSU, Frederic, San Diego CA 92121-1714 (US); CHOKSI, Ojas, M., San Diego CA 92121-1714 (US)
(74) Representative: Tomkins & Co
(86) International application number: PCT/US2008/076324
(87) International publication number: WO 2009/036399

(56) References cited:
- EP-A- 1 521 376
- EP-A- 1 833 161
- WO-A-97/26710
- JP-A- 2003 283 361
- US-A1- 2002 118 065
- US-A1- 2004 253 936
- US-A1- 2007 247 212
- US-B1- 6 590 438

## Description

### TECHNICAL FIELD

The disclosure relates to communications devices and, more particularly, to techniques for adjusting the size of local oscillator buffers and mixers in communications devices.

### BACKGROUND

In a communications system, a transmitter may upconvert a baseband signal into a radio-frequency (RF) signal by mixing the baseband signal with a local oscillator (LO) signal using a mixer. A receiver may receive the RF signal from the transmitter and downconvert the received signal from RF to baseband, also by mixing the RF signal with an LO signal using a mixer. In both the transmitter and receiver, an LO buffer may be provided to buffer an LO signal before providing it to the mixer.

The optimal sizes for the mixer and the LO buffer depend on the requirements of the transmitter or receiver. For example, in a transmitter, the sizes of the mixer and LO buffer may depend on the total transmit power required from the transmitter. See, e.g., U.S. Patent Application Serial No. 11/855,997, earlier referenced herein. In a receiver, larger mixer size tends to improve receiver linearity, while a smaller mixer size reduces
power consumption. Employing a larger mixer size usually mandates a correspondingly larger LO buffer, as the size of the mixer directly determines the load on the LO buffer.

In conventional transmitters and receivers, the sizes of the LO buffer and mixer are fixed. It would be desirable to dynamically adjust the size of the LO buffer and/or mixers depending on the requirements of the transmitter or receiver.

Document WO 97/26710 discloses a communication apparatus in which the sizes of mixers and local oscillator buffers are configured by selecting a mixer and a corresponding local oscillator buffer and by further controlling the gain of the mixer by controlling the current supply thereto.

Document JP2003-283361 A discloses a communication apparatus in which the gains of the local oscillator buffer and the mixer are separately configurable by way of control of the current supplies. In some embodiments additional transistors are switched in parallel in the signal path of the mixer.

### SUMMARY

As described herein with reference to the appended claims there is a communications apparatus according to claim 1 and a method for selecting a size of at least one component in a transmitter according to claim 7.

### BRIEF DESCRIPTION OF DRAWINGS

FIG 1 depicts a portion of a receiver unit 100 known in the prior art.
FIG 2 shows an example of an in-phase LO buffer and mixer, which however does not form part of the currently-claimed invention.
FIG 3 depicts an embodiment of the present invention, wherein the sizes of the LO buffer and mixer are made separately configurable.
FIG 4 depicts a conventional Gilbert multiplier architecture.
FIG 5 depicts a detailed view of a circuit topology by which the size of one of the transistors, Ml, coupled to the signal LO(+) in FIG 4, is made adjustable according to the present disclosure.
FIG 6 depicts an exemplary embodiment of an LO buffer with adjustable sizes.
FIG 7 depicts an example of an LO buffer with an adjustable size which however does not form part of the currently-claimed invention.
FIG 8 depicts an example of a transmitter utilizing a mixer and LO buffer having selectable size.
FIG 9 depicts an exemplary method according to the present disclosure.

### DETAILED DESCRIPTION

The detailed description set forth below in connection with the appended drawings is intended as a description of exemplary embodiments of the present invention and is not intended to represent the only embodiments in which the present invention can be practiced. The term "exemplary" used throughout this description means "serving as an example, instance, or illustration," and should not necessarily be construed as preferred or advantageous over other exemplary embodiments. The detailed description includes specific details for the purpose of providing a thorough understanding of the exemplary embodiments of the invention. It will be apparent to those skilled in the art that the exemplary embodiments of the invention may be practiced without these specific details. In some instances, well known structures and devices are shown in block diagram form in order to avoid obscuring the novelty of the exemplary embodiments presented herein.

In accordance with the present disclosure, techniques are disclosed for dynamically adjusting the sizes of the LO buffer and/or mixer depending on the requirements of a receiver or transmitter.

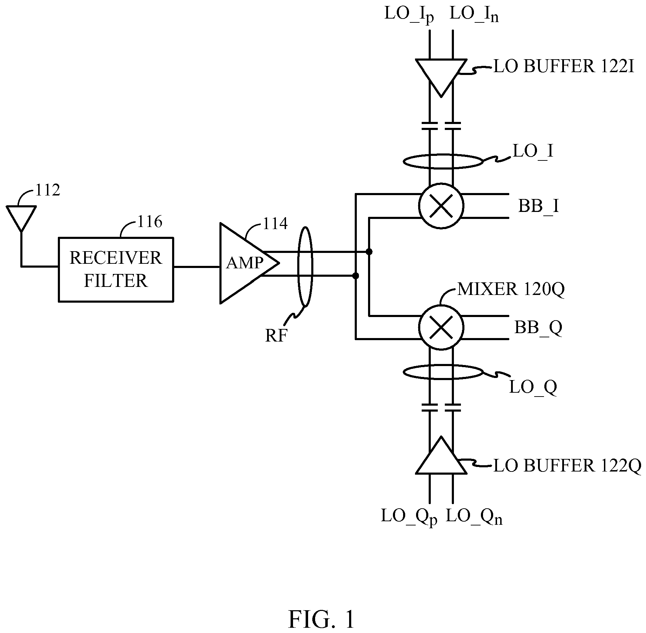

FIG 1 depicts a portion of a receiver unit 100 known in the prior art. Receiver unit 100 may be implemented within a terminal or a base station of a wireless (e.g., CDMA) communication system. Note other RF receiver designs may also be used and are within the scope of the present disclosure.

In FIG 1, one or more RF modulated signals transmitted from one or more transmitters (e.g., base stations, GPS satellites, broadcast stations, and so on) are received by an antenna 112 and provided to a receiver filter 116. The filtered signal is then provided to an amplifier (Amp) 114. Amplifier 114 amplifies the received signal with a particular gain to provide an amplified RF signal. Amplifier 114 may include one or more low noise amplifier (LNA) stages designed to provide a particular range of gains and/or attenuation. The amplified RF signal is provided to mixers 1201 and 120Q. Note the output of the amplifier 114 may be a differential signal, as shown in FIG 1.

Mixers 1201 and 120Q perform quadrature downconversion of the filtered RF signal from RF to baseband (BB). This may be achieved by multiplying (or mixing) the filtered RF signal with a complex local oscillator (LO) signal to provide a complex baseband signal. In particular, the filtered RF signal may be mixed with an inphase LO signal LO I by mixer 1201 to provide an inphase (I) baseband component BB I. The filtered RF signal may also be mixed with a quadrature-phase LO signal LO Q by mixer 120Q to provide a quadrature (Q) baseband component BB Q. BB I and BB Q may be subsequently processed by additional blocks (not shown), e.g., a channel filter, a variable gain amplifier (VGA), and/or an analog-to-digital converter (ADC).

Note while this specification may refer to exemplary embodiments wherein the RF signal is directly mixed to baseband, exemplary embodiments wherein the RF signal is mixed to a non-zero intermediate frequency (IF) are also within the scope of the disclosure.

In FIG 1, LO I is provided to mixer 1201 via an LO buffer 1221, whose input is a differential signal LO Ip - LO In. Similarly, LO Q is provided to mixer 120Q via an LO buffer 122Q, whose input is a differential signal LO Qp - LO Qn. In a conventional receiver, the size of the mixers 1201 and 120Q, and the size of the LO buffers 1221 and 122Q, are fixed. Note in this specification and in the claims, the "size" of a buffer or a mixer may be understood to encompass the width of any or all transistors in the signal path of such a buffer or mixer.

According to the present disclosure, techniques are provided for adjusting the size of the mixer and/or LO buffer, and for dynamically configuring the sizes based on the requirements of the apparatus.

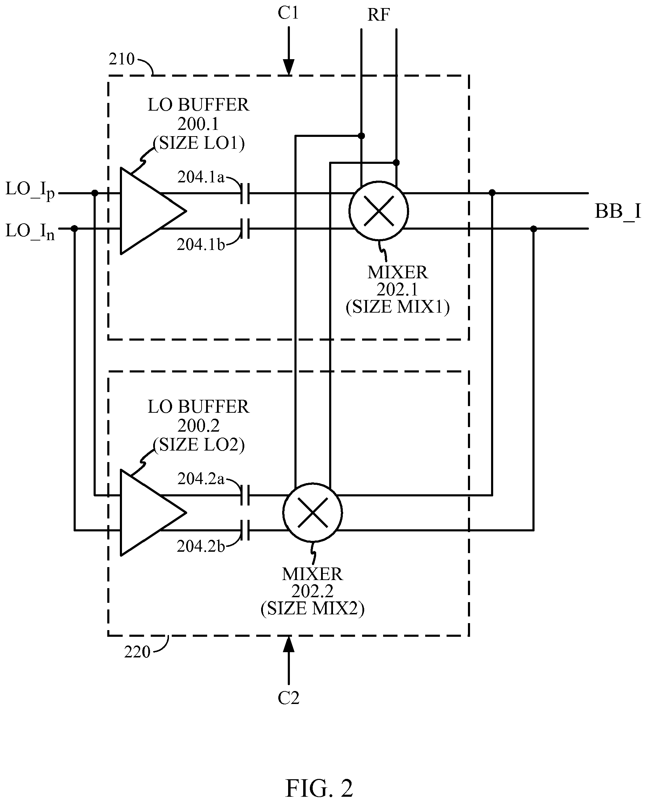

FIG 2 shows an example of an in-phase LO buffer and mixer, which however does not form part of the currently-claimed invention. One of ordinary skill in the art will realize that the techniques described may be directly applied to a quadrature -phase buffer and mixer. In the exemplary embodiment shown, the mixer has a current output. One of ordinary skill in the art may readily modify FIG 2 to accommodate mixers having voltage outputs.

In FIG 2, a differential LO signal LO_Ip - LO_In is provided to an LO buffer 200.1 of size LOl. The output of buffer 200.1 is coupled to the input of a mixer 202.1 of size MIX1 via coupling capacitors 204.1a and 204.1b. The signal path associated with buffer 200.1, mixer 202.1, and capacitors 204.1a and 204.1b (collectively labeled 210) may be referred to as the first signal path.

Similarly, the differential LO signal LO_Ip - LO_In is also provided to an LO buffer 200.2 of size LO2, whose output is coupled to the input of a mixer 202.2 of size MIX2 via coupling capacitors 204.2a and 204.2b. The signal path associated with buffer 200.2, mixer 202.2, and capacitors 204.2a and 204.2b (collectively labeled 220) may be referred to as the second signal path.

In FIG 2, control signals C1 and C2 selectively enable or disable the first and second signal path, respectively. This may be done by turning on or off the LO buffer and/or the mixer in the signal path, or by opening or closing a switch (not shown) placed in series with each signal path. One of ordinary skill in the art will recognize that a signal path may be selectively enabled or disabled using a variety of techniques not explicitly described herein.

The effective size of the LO buffer and mixer can be configured by selectively enabling the first, second, or both signal paths.

In particular, if the first signal path is enabled, and the second signal path is disabled, then the effective LO buffer size is LO1, and the effective mixer size is MIX1. Conversely, if the first signal path is disabled, and the second signal path is enabled, then the LO buffer size is LO2, and the mixer size is MIX2. Both signal paths may also be simultaneously enabled.

In a specific example LO2 is twice the value of LO1, and MIX2 is twice the value of MIXI. In this case, by setting control signals C1 and C2, the effective LO buffer / mixer size can be selected from a first size (first path enabled), a second size twice the first size (second path enabled), and a third size three times the first size (both paths enabled).

Note that in general, the sizes LO2, LO1, MIX2, and MIX1 may be arbitrarily chosen to have any relationship with each other. Any combination of sizes is contemplated to be within the scope of the present disclosure.

One of ordinary skill in the art will realize that the example shown in FIG 2 may be readily modified to accommodate more than two signal paths, e.g., three or more signal paths, providing even greater choice in the range of configurable buffer and mixer sizes.

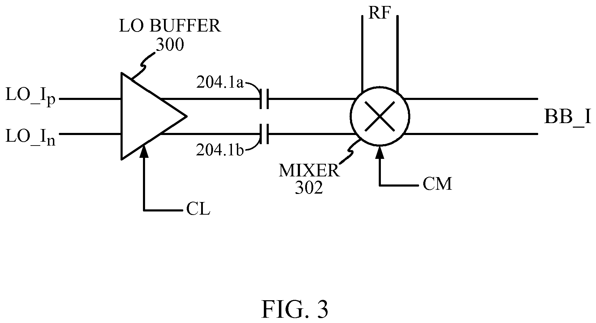

FIG 3 depicts an exemplary embodiment of the present invention, wherein the sizes of the LO buffer and mixer are made separately configurable. In FIG 3, a control signal CL selects a size of the LO buffer 300. Similarly, a control signal CM selects a size of the mixer 302. Note CL and CM may each comprise a plurality of sub-signals, depending on the number of sizes that are selectable within each block.

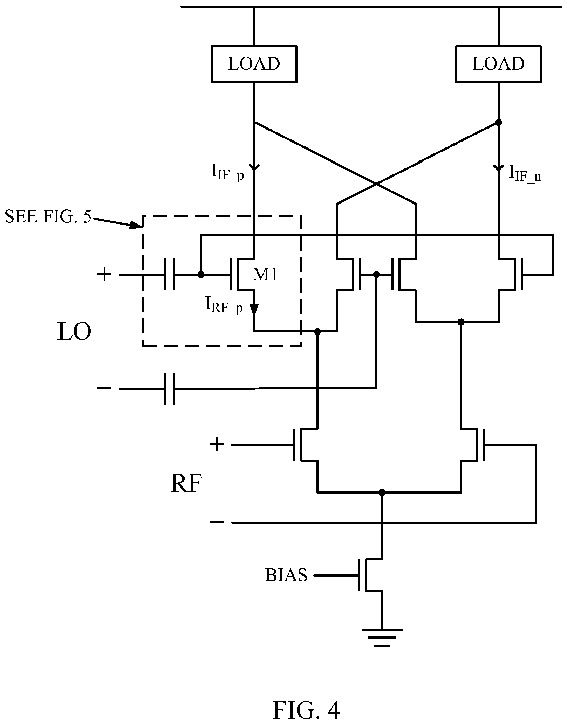

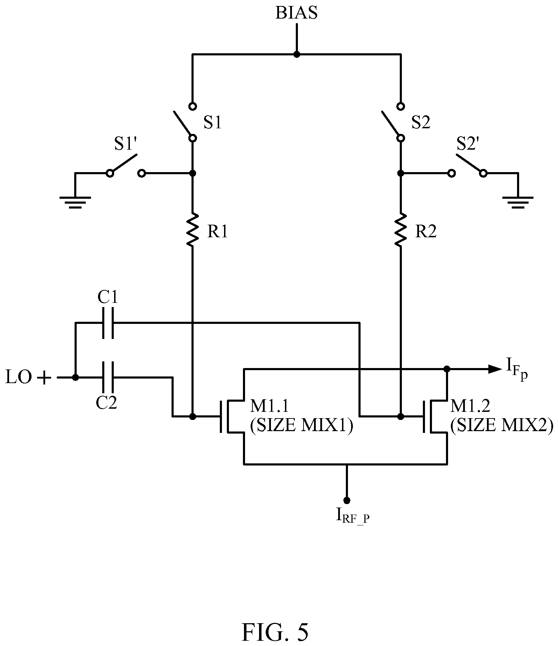

In an exemplary embodiment, a mixer having adjustable sizes may be implemented by modifying a Gilbert multiplier architecture using the techniques described herein with reference to FIGs 4 and 5.

FIG 4 depicts a Gilbert multiplier architecture. In FIG 4, a RF signal (RF) is multiplied to a local oscillator signal (LO) to generate a differential output current I1Fj - I1F n- The operation of Gilbert multipliers is well known in the art, and will not be described further herein. Note FIG 4 does not show the gate biasing arrangement for the transistors of the Gilbert multiplier.

According to the present disclosure, the size of the transistors coupled to the LO in FIG 4 may be made adjustable according to the exemplary embodiment of FIG 5.

FIG 5 depicts a detailed view of a circuit topology by which the size of one of the transistors, Ml, coupled to the signal LO(+) in FIG 4, is made adjustable according to the present disclosure. One of ordinary skill in the art may readily apply the techniques depicted in FIG 5 to make the size of the other transistors in FIG 4 adjustable. Such exemplary embodiments are contemplated to be within the scope of the present disclosure.

In FIG 5, transistor Ml is replaced by two transistors M1 .1 and M1 .2 having sizes MIX1 and MIX2, respectively. Transistors M 1.1 and M 1.2 are each coupled by a coupling capacitor or C2 to the positive output of the LO buffer, LO(+). M 1.1 and Ml .2 are also coupled via bias resistance R1 or R2 to either ground or a bias voltage Vbias via switches S1/ S1' and S2 / S2'. According to the present disclosure, switch S1 is closed when S1' is open, and vice versa, and similarly for switches S2 / S2'. The state of the switches may be controlled by the control signal CM provided to the mixer, as shown in FIG 3.

The operation of the circuit shown in FIG 5 may be characterized as follows. When S1 is closed and S2 is open, M 1.1 is turned on, and M 1.2 is turned off. This is because the gate of M 1.1 is coupled to Vbias, while the gate of M 1.2 is coupled to ground. In this case, the effective size of the transistor Ml as presented to the positive output of the LO buffer LO(+) is MIX1. Similarly, when S2 is closed and S1 is open, M 1.2 is turned on, and M 1.1 is turned off. In this case, the effective size of the transistor Ml is MIX2. Finally, when S1 and S2 are both closed, then both M 1.1 and M1.2 are turned on. In this case, the effective size of the transistor Ml is MIX1 + MIX2.

In an exemplary embodiment, the size MIX2 can be twice as large as MIX1. In this case, the size of transistor Ml is selectable effectively among MIX1, 2* MIX1, and 3* MIX1, by configuring the switches S1 and S2 as described above. Note in general, the values of MIX2 and MIX1 can have any relationship with each other.

One of ordinary skill in the art may readily modify the design depicted in FIG 5 to accommodate more than the two transistors shown, to allow for further configurability using more selectable sizes. Note the control signal provided to the switches, e.g., CM according to FIG 3, may be readily modified to accommodate more than two switches. Such exemplary embodiments are contemplated to be within the scope of the disclosure.

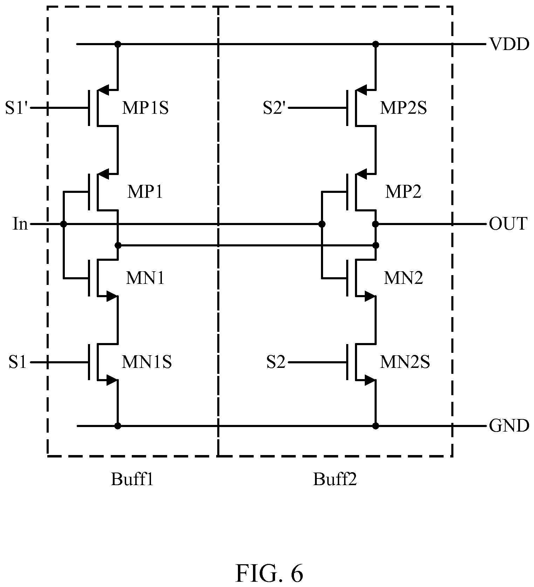

FIG 6 depicts an exemplary embodiment of an LO buffer with adjustable sizes according to the present disclosure.

In FIG 6, a first amplifier Buff1 includes active transistors MP1 and MN1 driven by an input signal In. Coupled in series with MN1 and MP1 are switches MN1S and MP1S controlled by S1 and S1', respectively. In an exemplary embodiment, S1' is the inverse of S 1, i.e. , S 1 ' is high when S 1 is low, and vice versa. The drains of MN1 and MP1 are coupled to the output signal Out.

A second amplifier Buff2 similarly includes active transistors MP2 and MN2 driven by the input signal In. Coupled in series with MN2 and MP2 are switches MN2S and MP2S controlled by signals S2 and S2', respectively. In an exemplary embodiment, S2' is the inverse of S2, i.e., S2' is high when S2 is low, and vice versa. The drains of MN2 and MP2 are also coupled to the output signal Out.

The operation of the circuit in FIG 6 may be characterized as follows. When S1 is high and S2 is low, then Buff1 is turned on, and Buff2 is turned off. This is because the switches S1 and S1' are turned on, while S2 and S2' are turned off. In this case, the effective size of the LO buffer corresponds to the gate sizes of transistors MP1 and MN1. Similarly, when S2 is high and S1 is low, then Buff2 is turned on, and Buff1 is turned off. In this case, the effective size of the LO buffer corresponds to the gate sizes of transistors MP2 and MN2. Finally, when S1 and S2 are both high, then both Buff1 and Buff2 are turned on. In this case, the effective size of the LO buffer corresponds to the combined gate sizes of MP2 and MP1, and the combined gate sizes of MN2 and MN1.

By configuring the signals S1 and S2, the effective size of the LO buffer is selectable among that of MP1/MN1 (Buff1 turned on), MP2/MN2 (Buff2 turned on), or MP1/MN1/MP2/MN2 (Buff1 and Buff2 turned on). In general, the sizes of the transistors can have any relationship with each other. In an exemplary embodiment, MP2 and MN2 are twice as large as MP1 and MN1, respectively.

One of ordinary skill in the art may readily modify the design depicted in FIG 6 to accommodate more than the two buffers shown, to allow for further configurability using more selectable sizes. Note the control signal provided to the switches, e.g., CL according to FIG 3, may also be readily modified to accommodate more than two switches. Such exemplary embodiments are contemplated to be within the scope of the disclosure.

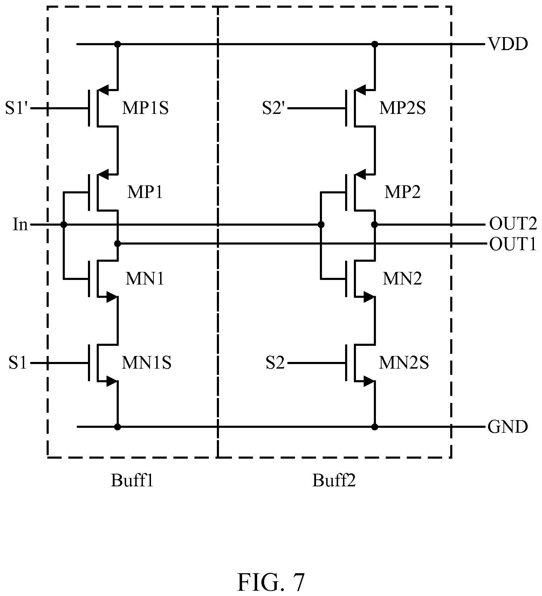

FIG 7 depicts an example of an LO buffer with an adjustable size, configured to drive separate mixers which however does not form part of the currently-claimed invention. The operation of the example in FIG 7 is identical to that of the exemplary embodiment in FIG 6, except that the output OUT1 of the first buffer Buff1 is kept separate from the output OUT2 of the second buffer Buff2. In this way, Buff1 in Buff2 in FIG 7 may be employed as LO Buffer 200.1 and LO Buffer 200.2 in FIG 2, i.e., to drive two separate mixers 202.1 and 202.2.

According to the present disclosure, techniques have been provided for selectable LO buffer and/or mixer sizes in a receiver circuit. Another aspect of the present disclosure provides for selection of LO buffer and/or mixer sizes based on an operating mode of the receiver.

In a typical implementation of the receiver in FIG 1, the overall gain of the receiver chain may take on a plurality of values depending on the received signal strength. For example, when the received signal strength is high, the receiver chain may be configured to have a low overall gain. Conversely, when the received signal strength is low, the receiver chain may be configured to have a high gain. The gain may be configured by, e.g., programming the gain of the LNA and/or mixer to the desired levels.

According to the present disclosure, the LO buffer and/or mixer sizes may be selected depending on the gain mode of the receiver to minimize the current consumption in such gain mode.

In an embodiment, the LO buffer size may be made a function of the receiver gain mode. The LO buffer size may be increased in response to the receiver being switched from a lower gain to a higher gain mode. Alternatively, the LO buffer size may be decreased in response to the receiver being switched from a lower gain to a higher gain mode.

In an embodiment, the mixer size may also be made a function of the receiver gain mode. The mixer size may be increased in response to the receiver being switched from a lower gain mode to a higher gain mode. Alternatively, the mixer size may be decreased in response to the receiver being switched from a lower gain mode to a higher gain mode.

In an embodiment, when the receiver chain is configured to have a low gain, both the LO buffer and the mixer are configured to a first size. When the receiver chain is configured to have a high gain, both the LO buffer and mixer are configured to a second size larger than the first size. In this embodiment, the better linearity and phase noise characteristics afforded by a larger LO buffer and mixer are made available when receiving weak signals, while the lower current consumption afforded by a smaller LO buffer and mixer is made available when receiving strong signals.

In another exemplary embodiment, the circuitry described with reference to FIGs 5 and 6 may be employed by configuring the switches and control signals described with reference thereto based on the receiver gain mode. In yet another exemplary embodiment, any circuit topology allowing for selectable size of a buffer and/or mixer may be employed in the configuration of FIG 3, with control signals CL and/or CM configured to depend on the receiver gain mode.

One of ordinary skill in the art will realize that the any number of receiver gain modes greater than two may be associated with a corresponding number of selectable LO buffer and/or mixer sizes. Such exemplary embodiments incorporating more than two modes are contemplated to be within the scope of the present disclosure.

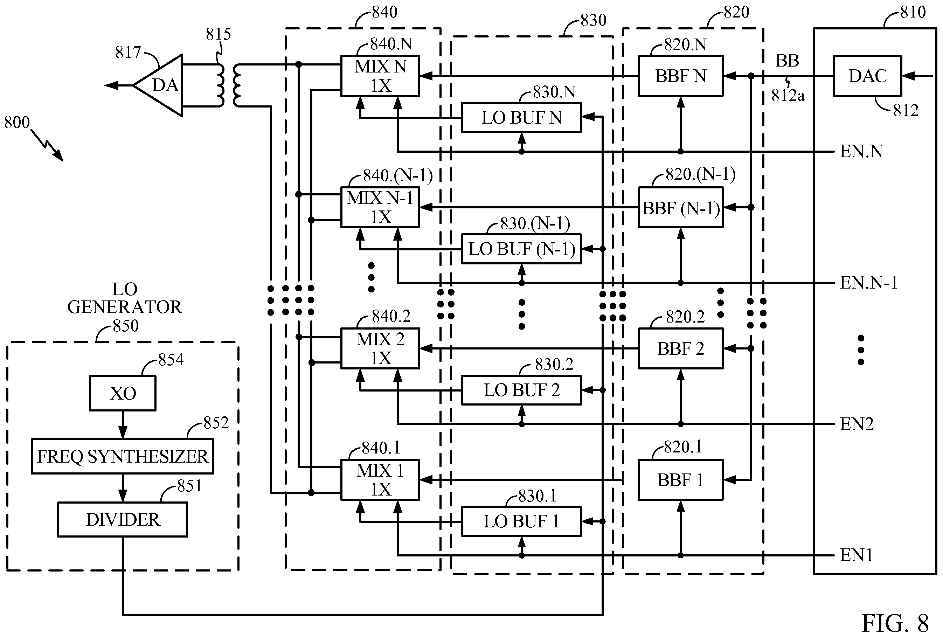

FIG 8 depicts an example of a transmitter 800 utilizing a mixer and LO buffer having selectable size, which however does not form part of the currently-claimed invention. In FIG 8, mixer 840 is composed of sub-mixers 840.1 through 840.N, and LO buffer 830 is composed of sub-LO buffers 830.1 through 830.N associated with each of the sub- mixers. Note each of the sub-mixers 840.1 through 840. N shown may include a plurality of separate mixer circuits including, e.g., an I mixer, an inverse I mixer (for differential processing), a Q mixer, and an inverse Q mixer. Similarly, each of the sub- LO buffers 830.1 through 830.N shown may include a plurality of separate LO buffer circuits for each of the plurality of separate mixer circuits.

In FIG 8, the sub-mixers 840.1 through 840.N and sub-LO buffers 830.1 through 830.N may be selectively enabled or disabled by a baseband processor 810 using control signals EN.1 through EN .N, respectively. Each sub-mixer mixes a corresponding buffered LO signal with a baseband signal generated by the baseband processor 810, filtered by selectable baseband filters 820.1 through 820.N. The mixed output signals of the sub-mixers are coupled via coupling element 815 to a driver amplifier 817 for further transmission, e.g., over an antenna via a power amplifier (not shown).

In the transmitter 800, the baseband processor 810 may select which of the sub-mixers, sub-LO buffers, and baseband filters to enable, based on criteria including, e.g., total gain of the transmit power required to be delivered to the driver amplifier. For example, to operate in a lowest gain mode, only sub-mixer 840.1, sub-LO buffer 830.1, and baseband filter 820.1 may be enabled, with the remaining sub-mixers, sub-LO buffers, and baseband filters disabled. This mode may correspond to operating the transmitter 800 with a mixer and LO buffer of minimum size. To operate in a highest gain mode, all of sub-mixers 840.1 through 840.N, sub-LO buffers 830.1 through 830.N, and baseband filters 820.1 through 820.N may be enabled. This mode may correspond to operating the transmitter 800 with a mixer and LO buffer of maximum size. One of ordinary skill in the art will appreciate that a mixer and LO buffer of an intermediate size may be obtained by enabling a corresponding subset of the sub-mixers and sub-LO buffers.

In a specific example, each instance of the sub-mixer, sub-LO buffer, and baseband filter may be designed to have identical characteristics to every other instance of the sub-mixer, sub-LO buffer, and baseband filter, respectively, so that the gain steps of the transmit power may be precisely controlled. This may be achieved by, e.g., designing the circuit blocks to have identical physical layout to each other on a semiconductor chip, and/or placing the circuit blocks in close physical proximity to each other, and/or locating the circuit blocks symmetrically relative to the LO signal. In FIG 8, the sub-mixers 840.1 through 840. N are all shown as having identical size to each other, i.e., with a "Ix" size multiplier. One of ordinary skill in the art will appreciate that the sub-mixers need not have the same size relative to each other, and may generally have varying sizes, e.g., binary-weighted sizes to facilitate efficient selection of transmit power step size by the baseband processor 810.

In FIG 8, the local oscillator signal is generated by an LO generator 850, which includes a frequency divider 851 coupled to the output of a frequency synthesizer 852, which is in turn coupled to a crystal oscillator 854. In an exemplary embodiment, the circuit blocks of the LO generator 850 may be kept physically separate from each instance of the sub-mixer / sub-LO buffer / baseband filter, with the output signal of a single instance of a frequency divider 851 coupled to multiple instances 830.1 through 830.N of the LO buffer. Since there is only one frequency divider 850, synchronization of multiple instances of a frequency divider may not be required in the transmitter 800.

Note the techniques described herein for the scalable transmitter architecture 800 are not meant to limit the scope of the present disclosure to any particular implementations of transmitters shown. In alternative exemplary embodiments (not shown), the techniques of the present disclosure may be adopted in transmitters employing additional circuit elements not shown, such as additional gain control elements or filters. The techniques may also be adopted in transmitters employing fewer circuit elements than shown, e.g., wherein the baseband filters 820.1 through 820.N are directly integrated into the baseband processor 810, or wherein only a single baseband filter is provided for all sub-mixers. Such exemplary embodiments are contemplated to be within the scope of the present disclosure.

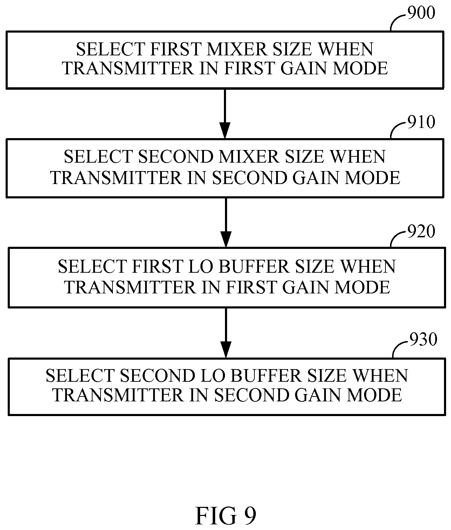

FIG 9 depicts an exemplary method. Note the method is shown for illustration only, and is not meant to limit the scope of the present application to any particular method disclosed, or to any particular sequence of steps disclosed.

At step 900, the method selects a first mixer size for when the transmitter is in a first gain mode.

At step 910, the method selects a second mixer size for when the transmitter is in a second gain mode.

At step 920, the method selects a first LO buffer size when the transmitter is in the first gain mode.

At step 930, the method selects a second LO buffer size when the transmitter is in the second gain mode.

Note one of ordinary skill in the art will appreciate that the techniques described may generally be applied to both transmitter and receiver embodiments, and should not be limited only to the specific exemplary embodiments shown.

Those of skill in the art would understand that information and signals may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

Those of skill would further appreciate that the various illustrative logical blocks, modules, circuits, and algorithm steps described in connection with the embodiments disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the exemplary embodiments of the invention.

The various illustrative logical blocks, modules, and circuits described in connection with the embodiments disclosed herein may be implemented or performed with a general purpose processor, a Digital Signal Processor (DSP), an Application Specific Integrated Circuit (ASIC), a Field Programmable Gate Array (FPGA) or other programmable logic device, discrete gate or transistor logic, discrete hardware components, or any combination thereof designed to perform the functions described herein. A general purpose processor may be a microprocessor, but in the alternative, the processor may be any processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

The steps of a method or algorithm described in connection with the embodiments disclosed herein may be embodied directly in hardware, in a software module executed by a processor, or in a combination of the two. A software module may reside in Random Access Memory (RAM), flash memory, Read Only Memory (ROM), Electrically Programmable ROM (EPROM), Electrically Erasable Programmable ROM (EEPROM), registers, hard disk, a removable disk, a CD-ROM, or any other form of storage medium known in the art. An exemplary storage medium is coupled to the processor such that the processor can read information from, and write information to, the storage medium. In the alternative, the storage medium may be integral to the processor. The processor and the storage medium may reside in an ASIC. The ASIC may reside in a user terminal. In the alternative, the processor and the storage medium may reside as discrete components in a user terminal.

In one or more exemplary embodiments, the functions described may be implemented in hardware, software, firmware, or any combination thereof. If implemented in software, the functions may be stored on or transmitted over as one or more instructions or code on a computer-readable medium. Computer-readable media includes both computer storage media and communication media including any medium that facilitates transfer of a computer program from one place to another. A storage media may be any available media that can be accessed by a computer. By way of example, and not limitation, such computer-readable media can comprise RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Also, any connection is properly termed a computer-readable medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. Disk and disc, as used herein, includes compact disc (CD), laser disc, optical disc, digital versatile disc (DVD), floppy disk and blu-ray disc where disks usually reproduce data magnetically, while discs reproduce data optically with lasers. Combinations of the above should also be included within the scope of computer-readable media.

The previous description of the disclosed exemplary embodiments is provided to enable any person skilled in the art to make or use the present invention. Various modifications to these exemplary embodiments will be readily apparent to those skilled in the art, and the generic principles defined herein may be applied to other embodiments without departing from the scope of the invention as defined by the claims.

In this specification and in the claims, it will be understood that when an element is referred to as being "connected to" or "coupled to" another element, it can be directly connected or coupled to the other element or intervening elements may be present. In contrast, when an element is referred to as being "directly connected to" or "directly coupled to" another element, there are no intervening elements present.

A number of embodiments have been described. However, various modifications to these embodiments are possible, and the principles presented herein may be applied to other aspects within the scope of the following claims.

## Claims

1. A communications apparatus, comprising:
a local oscillator buffer (300), and
a mixer (302), wherein the output of the buffer (300) is coupled to the input of the mixer (302); and wherein the size of the local oscillator buffer (300) and the size of mixer (302) are separately configurable in operation in response to the requirements of the apparatus, where the size of the local oscillator buffer (300) encompasses the width of transistors in a signal path of the buffer and wherein the size of the mixer (302) encompasses the width of transistors in the signal path of the mixer and further comprising a local oscillator control signal for selecting the size of the local oscillator buffer (300), the apparatus further comprising a mixer control input for selecting the size of the mixer (302).

2. The apparatus of claim 1, the local oscillator buffer (300) and the mixer (302) being included in a transmitter of the apparatus.

3. The apparatus of claim 2, the local oscillator buffer (300) comprising:
a first sub- buffer having an input coupled to a local oscillator signal and an output coupled to a buffered local oscillator signal; and
a second sub- buffer having an input coupled to the local oscillator signal and an output coupled to the buffered local oscillator signal.

4. The apparatus of claim 3, the local oscillator control signal being for selectively enabling the first sub-buffer or the second sub-buffer.

5. The apparatus of claim 2, the mixer (302) being a Gilbert multiplier, the buffered local oscillator signal being a differential signal, the mixer comprising:
a first transistor having a gate coupled to the buffered local oscillator signal, the mixer further comprising a first transistor control input for turning on and turning off the first transistor; and
a second transistor having a gate coupled to the buffered local oscillator signal, the mixer further comprising a second transistor control input for turning on and turning off the second transistor.

6. The apparatus of claim 5, the second transistor having a size twice that of the first transistor where the size relates to the width of the transistors in a signal path of the apparatus.

7. A method for selecting a size of at least one component in a transmitter, the transmitter comprising a mixer and a local oscillator buffer, wherein the output of the buffer is coupled to the input of the mixer the method comprising:
separately configuring in operation the size of the local oscillator buffer and the size of the mixer in response to the requirements of the transmitter where the size of the local oscillator buffer (300) encompasses the width of transistors in a signal path of the buffer and wherein the size of the mixer (302) encompasses the width of transistors in the signal path of the mixer and further comprising providing a local oscillator control signal for selecting the size of the local oscillator buffer (300), and providing a mixer control input for selecting the size of the mixer (302).

## Patentansprüche

1. Eine Kommunikationsvorrichtung, aufweisend:
einen lokalen Oszillatorpuffer (300), und
einen Mischer (302), wobei der Ausgang des Puffers (300) mit dem Eingang des Mischers (302) gekoppelt ist und wobei die Größe des lokalen Oszillatorpuffers (300) und die Größe des Mischers (302) während des Betriebs in Antwort auf die Anforderungen der Vorrichtung separat konfiguriert werden können, wobei die Größe des lokalen Oszillatorpuffers (300) die Breite von Transistoren in einem Signalpfad des Puffers umfasst und die Größe des Mischers (302) die Breite von Transistoren in dem Signalpfad des Mischers umfasst, wobei in der Vorrichtung ein Lokaler-Oszillator-Steuersignal für das Auswählen der Größe des lokalen Oszillatorpuffers (300) vorgesehen wird und weiterhin eine Mischersteuereingabe für das Auswählen der Größe des Mischers (302) vorgesehen wird.

2. Vorrichtung nach Anspruch 1, wobei der lokale Oszillatorpuffer (300) und der Mischer (302) in einem Sender der Vorrichtung enthalten sind.

3. Vorrichtung nach Anspruch 2, wobei der lokale Oszillatorpuffer (300) aufweist:
einen ersten Subpuffer, der einen mit einem Lokaler-Oszillator-Signal gekoppelten Eingang und einen mit einem gepufferten Lokaler-Oszillator-Signal gekoppelten Ausgang aufweist, und
einen zweiten Subpuffer, der einen mit dem Lokaler-Oszillator-Signal gekoppelten Eingang und einen mit dem gepufferten Lokaler-Oszillator-Signal gekoppelten Ausgang aufweist.

4. Vorrichtung nach Anspruch 3, wobei das Lokaler-Oszillator-Steuersignal dazu dient, selektiv den ersten Subpuffer oder den zweiten Subpuffer zu aktivieren.

5. Vorrichtung nach Anspruch 2, wobei der Mischer (302) ein Gilbert-Multiplizierer ist, wobei das gepufferte Lokaler-Oszillator-Signal ein differentielles Signal ist, wobei der Mischer aufweist:
einen ersten Transistor, der ein mit dem gepufferten Lokaler-Oszillator-Signal gekoppeltes Gate aufweist, wobei der Mischer weiterhin einen ersten Transistor-Steuereingang zum Einschalten und Ausschalten des ersten Transistors aufweist, und
einen zweiten Transistor, der ein mit dem gepufferten Lokaler-Oszillator-Signal gekoppeltes Gate aufweist, wobei der Mischer weiterhin eine zweiten Transistor-Steuereingang zum Einschalten und Ausschalten des zweiten Transistors aufweist.

6. Vorrichtung nach Anspruch 5, wobei der zweite Transistor eine doppelt so große Größe aufweist wie der erste Transistor, wobei sich die Größe auf die Breite der Transistoren in einem Signalpfad der Vorrichtung bezieht.

7. Ein Verfahren zum Auswählen der Größe wenigstens einer Komponente in einem Sender, wobei der Sender einen Mischer und einen lokalen Oszillatorpuffer aufweist, wobei der Ausgang des Puffers mit dem Eingang des Mischers gekoppelt ist, wobei das Verfahren aufweist:
separates Konfigurieren, während des Betriebs, der Größe des lokalen Oszillatorpuffers und der Größe des Mischers in Antwort auf die Anforderungen des Senders, wobei die Größe des lokalen Oszillatorpuffers (300) die Breite von Transistoren in einem Signalpfad des Puffers umfasst und die Größe des Mischers (302) die Breite von Transistoren in dem Signalpfad des Mischers umfasst, Vorsehen eines Lokaler-Oszillator-Steuersignals für das Auswählen der Größe des lokalen Oszillatorpuffers (300) und Vorsehen einer Mischersteuereingabe für das Auswählen der Größe des Mischers (302).

## Revendications

1. Appareil de communication comprenant :
une mémoire tampon d'un oscillateur local (300), et
un mélangeur (302), dans lequel la sortie de la mémoire tampon (300) est couplé à l'entrée du mélangeur (302) ; et dans lequel la taille de la mémoire tampon (300) de l'oscillateur local ainsi que la taille du mélangeur (302) sont configurables séparément en fonctionnement en fonction des exigences de l'appareil, dans lequel la taille de la mémoire tampon (300) de l'oscillateur local englobe la largeur des transistors dans un chemin de signal de la mémoire tampon et dans lequel la taille du mélangeur (302) englobe la largeur des transistors dans le chemin le signal du mélangeur et comprenant en outre un signal de commande de l'oscillateur local pour sélectionner la taille de la mémoire tampon (300) de l'oscillateur local, l'appareil comprenant en outre une entrée de commande du mélangeur pour sélectionner la taille du mélangeur (302).

2. Appareil selon la revendication 1, la mémoire tampon de l'oscillateur local (300) et le mélangeur (302) faisant partie d'un émetteur de l'appareil.

3. Appareil selon la revendication 2, la mémoire tampon de l'oscillateur local (300) comprenant:
un premier sous-tampon ayant une entrée couplée à un signal de l'oscillateur local et une sortie couplée à un signal de l'oscillateur local tamponné ; et
un deuxième sous-tampon ayant une entrée couplée au signal de l'oscillateur local et une sortie couplée au signal de l'oscillateur local tamponné.

4. Appareil selon la revendication 3, le signal de commande de l'oscillateur local servant à valider sélectivement le premier sous-tampon ou le deuxième sous-tampon.

5. Appareil selon la revendication 2, le mélangeur (302) étant un multiplicateur de Gilbert, le signal de l'oscillateur local tamponné étant un signal différentiel, le mélangeur comprenant :
un premier transistor ayant une grille couplée au signal de l'oscillateur local tamponné, le mélangeur comprenant en outre une première entrée de commande de transistor pour activer et pour désactiver le premier transistor ; et
un deuxième transistor ayant une grille couplée au signal de l'oscillateur local tamponné, le mélangeur comprenant en outre une deuxième entrée de commande de transistor pour activer et pour désactiver le deuxième transistor.

6. Appareil selon la revendication 5, le deuxième transistor ayant une taille double de celle du premier transistor dans lequel la taille concerne la largeur des transistors dans un chemin de signal de l'appareil.

7. Un procédé pour sélectionner une taille d'au moins un composant dans un émetteur, l'émetteur comprenant un mélangeur et une mémoire tampon d'un oscillateur local, dans lequel la sortie de la mémoire tampon est couplée à l'entrée du mélangeur, le procédé comprenant les étapes consistants à :
configurer séparément, en fonctionnement, la taille de la mémoire tampon de l'oscillateur local ainsi que la taille du mélangeur en réponse aux exigences de l'émetteur, dans lequel la taille de la mémoire tampon (300) de l'oscillateur local englobe la largeur des transistors dans un chemin de signal de la mémoire tampon et dans lequel la taille du mélangeur (302) englobe la largeur des transistors dans le chemin de signal du mélangeur et comprenant en outre les étapes consistant à fournir un signal de commande de l'oscillateur local pour sélectionner la taille de la mémoire tampon (300) de l'oscillateur local, et fournir une entrée de commande du mélangeur pour sélectionner la taille du mélangeur (302).
